# EUROPEAN PATENT APPLICATION

(11) **EP 4 739 025 A1**
(43) Date of publication of application: **06.05.2026**
(21) Application number: 24212406.3
(22) Date of filing: 12.11.2024
(51) Int. Cl.: H10B 63/00, H10N 70/20, H10N 70/00

(54) **MEMORY DEVICE WITH TUNEABLE THRESHOLD VOLTAGE**

(30) Priority: 31.10.2024 EP 24210168
(71) Applicant: IMEC VZW, 3001 Leuven (BE); Katholieke Universiteit Leuven KU Leuven Research & Development, 3000 Leuven (BE)
(72) Inventor: GARBIN, Daniele, 3000 Leuven (BE); RAVSHER, Taras, 3001 Heverlee (BE)
(74) Representative: Winger

(57) **Abstract**

A device (1) comprising:
a first electrode (4) comprising a first electrode material of a type that, if oxidized by an oxidizing agent, is electrically insulating,
a second electrode (2) comprising a second electrode material of a type that, if oxidized by said oxidizing agent, is electrically conducting, and
a threshold switch layer (3) between the first electrode (4) and the second electrode (2), the threshold switch layer (3) comprising a material being switchable from an electrically insulating state to an electrically conducting state by a voltage between the first (4) and second electrode (2) crossing a threshold voltage, and
a first electrode interface (40) between the threshold switch layer (3) and the first electrode (4), and a second electrode interface (20) between the threshold switch layer (3) and the second electrode (2),
wherein the device (1) comprises the oxidizing agent suitable for being moveable between the first electrode (4) and the second electrode (2), the threshold switch layer (3) providing a passage for moving the oxidizing agent between the first electrode (4) and the second electrode (2).

## Description

### Technical field of the invention

The present invention relates to the field of memory technology, and more specifically to storage-class memory devices utilizing chalcogenide materials.

### Background of the invention

Memory technology plays a critical role in the performance and efficiency of modern computing systems. As applications become increasingly data-intensive and demand rapid processing of large datasets, the requirements for memory solutions have become more stringent. Modern computer architectures utilize a hierarchical memory structure that combines different types of memory technologies to optimize performance and storage capacity. Dynamic random-access memory (DRAM) serves as the primary working memory due to its fast access times of approximately 10 nanoseconds, enabling quick data retrieval and processing. In contrast, NAND Flash memory provides non-volatile storage with larger capacities but slower access times of around 100 microseconds.

Despite significant advancements over the years, a considerable performance gap persists between volatile memory like DRAM and non-volatile storage solutions such as NAND Flash. This disparity poses challenges in achieving seamless system performance, as the slower access times of non-volatile memory can become a bottleneck for data-intensive applications requiring both speed and persistence. The need to bridge this gap has spurred interest in developing new memory technologies that can offer the high speed of DRAM while providing the non-volatility and cost benefits of NAND Flash.

Storage-Class Memory (SCM) emerges as a promising category of memory technology aimed at filling this niche. SCM seeks to deliver a balance of performance, capacity, and endurance, effectively integrating into the existing memory hierarchy between DRAM and traditional storage solutions. Several approaches are being explored to realize SCM, including the integration of novel materials and device architectures that can support faster access times and higher data densities.

At the moment, one of the promising candidates for this role is Phase-Change Memory (PCM) integrated in a cross-point array (which decreases costs by minimizing the area footprint of a single memory cell). However, for such an array to function properly, a highly non-linear selector element in series with PCM memory element (so-called 1S1R cell), which can suppress the unavoidable leakage current through half-selected cells, is required.

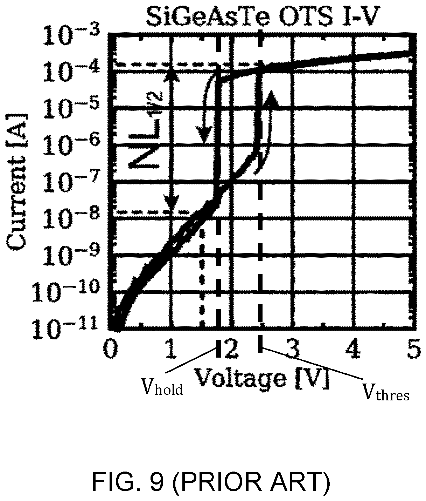

For this purpose, ovonic threshold switches (OTS) have been used. As illustrated in FIG. 9, a current-voltage diagram of a typical ovonic threshold switch (OTS) comprising a chalcogenide layer material is shown. The diagram demonstrates the highly nonlinear switching behavior of the OTS, where the current through the device abruptly increases when the applied voltage exceeds a certain threshold voltage (Vₜₕᵣₑₛ). When, subsequently, the applied voltage drops below a certain hold voltage (V_{hold}), the current through the device abruptly decreases. This nonlinear characteristic allows the OTS to act as a selector device in series with a memory element, suppressing leakage current through unselected cells in a cross-point memory array. Typically, the role of a selector is played by a chalcogenide-based ovonic threshold switch (OTS) device.

However, the development of this type of memory systems faces several challenges. One of the main problems of conventional 1S1R memory (containing an OTS layer stacked on a PCM layer) is related to the high aspect ratio of the memory cell. In particular, the PCM layer is typically much thicker than the OTS layer. High aspect ratio structures within these cells can complicate the manufacturing process, making precise patterning difficult and driving up fabrication costs. Indeed, the discrepancy in layer thicknesses in some memory cell designs contributes to these manufacturing complexities.

Advancements in materials science and fabrication techniques continue to address some of these challenges, but obstacles remain in achieving the optimal balance of performance, scalability, and cost-effectiveness. Consequently, there is still a need for further developments in memory technology to overcome these limitations and fully realize the potential of advanced memory solutions like SCM.

### Summary of the invention

It is an object of embodiments of the present invention to provide a good device, a good memory element comprising the device, a good memory apparatus comprising the memory element, and good programming and reading methods that may be applied on the memory elements.

The above objective is accomplished by devices and methods according to the present invention.

It is an advantage of embodiments of the present invention that a device having a tuneable threshold voltage may be provided, which may enable on-line tuning of the threshold voltage.

It is an advantage of embodiments of the present invention that the need for a thick phase-change memory layer may be eliminated, reducing the high aspect ratio and simplifying the patterning process.

It is an advantage of embodiments of the present invention that the threshold switch layer may serve both as a selector and as an oxidizing agent exchange layer.

It is an advantage of embodiments of the present invention that memory functionality may be integrated at an interface between a threshold switch layer and the metal electrodes, reducing device complexity.

It is an advantage of embodiments of the present invention that the device concept offers a lower-cost option for storage-class memory applications compared to existing solutions based on conventional 1S1R cell structures.

It is an advantage of embodiments of the present invention that the proposed device structure can implement a high-performance storage-class memory, bridging the performance gap in the existing memory hierarchy. It is, indeed, an advantage of embodiments of the present invention that high-speed, non-volatile memory may be achieved with lower access times compared to NAND Flash and reduced fabrication complexities compared to DRAM.

In a first aspect, the present invention relates to a device comprising:
a. a first electrode comprising a first electrode material of a type that, if oxidized by an oxidizing agent, is electrically insulating,
b. a second electrode comprising a second electrode material of a type that, if oxidized by said oxidizing agent, is electrically conducting, and
c. a threshold switch layer between the first electrode and the second electrode, the threshold switch layer comprising, or being formed of, a material being switchable from an electrically insulating state to an electrically conducting state by a voltage between the first and second electrode crossing a threshold voltage, and
d. a first electrode interface between the threshold switch layer and the first electrode, and a second electrode interface between the threshold switch layer and the second electrode,
wherein the device comprises the oxidizing agent suitable for being moveable between the first electrode and the second electrode, the threshold switch layer providing a passage, or path, for moving the oxidizing agent between the first electrode and the second electrode.

The first electrode interface between the threshold switch layer and the first electrode may be an interface of the first electrode facing, or contacting, the threshold switch layer. The second electrode interface between the threshold switch layer and the second electrode may be an interface of the second electrode facing, or contacting, the threshold switch layer.

Typically, the device is arranged so that current moving between the first electrode and the second electrode flows through the threshold switch layer. Typically, the device is arranged so that current moving between the first electrode and the second electrode flows through the first electrode interface. Typically, the device is arranged so that current moving between the first electrode and the second electrode flows through the second electrode interface.

In embodiments, the first electrode interface is formed of, or substantially consists of, the first electrode material. In particular, the first electrode interface preferably does substantially not contain an electrode material that, if oxidized by the oxidizing agent, remains electrically conducting. In embodiments, the first electrode interface comprising the first electrode material oxidized by the oxidizing agent means that the first electrode comprises, at the first electrode interface, an oxidized interfacial layer comprising, or formed of, the oxidized first electrode material, the oxidized interfacial layer having a thickness - in a direction from the first electrode interface to the threshold switch layer - of at least 0.3 nm, for example, of from 0.3 nm to 10 nm. In these embodiments, the first electrode interface may comprise the oxidized interfacial layer. The oxidized interfacial layer, at the first electrode interface, comprising the oxidized first electrode material is typically electrically insulating.

In embodiments, the first electrode interface comprising the first electrode material oxidized by the oxidizing agent means that the first electrode interface comprises a substantially continuous or uniform layer of the oxidized first electrode material. It is an advantage of these embodiments that current flowing between the first electrode and the threshold switch layer effectively passes through said oxidized first electrode material. In embodiments, a standard deviation of the thickness is, throughout the oxidized interfacial layer of the oxidized first electrode material, at most 50%, preferably at most 20%, of said thickness.

In embodiments, the second electrode interface is formed of, or substantially consists of, the second electrode material. In particular, the second electrode interface preferably does substantially not contain an electrode material that, if oxidized by the oxidizing agent, becomes electrically insulating. In embodiments, the second electrode interface comprising the second electrode material oxidized by the oxidizing agent means that the second electrode comprises, at the second electrode interface, an oxidized interfacial layer comprising, or formed of, the oxidized second electrode material, the oxidized interfacial layer having a thickness - in a direction from the second electrode interface to the threshold switch layer-of at least 0.3 nm, for example, of from 0.3 nm to 10 nm. In these embodiments, the second electrode interface may comprise the oxidized interfacial layer. The oxidized interfacial layer, at the second electrode interface, comprising the oxidized second electrode material is typically electrically conducting.

In embodiments, the second electrode interface comprising the second electrode material oxidized by the oxidizing agent means that the second electrode interface comprises a substantially continuous or uniform layer of the oxidized second electrode material. It is an advantage of these embodiments that current flowing between the second electrode and the threshold switch layer effectively passes through said oxidized second electrode material. In embodiments, a standard deviation of the thickness is, throughout the oxidized interfacial layer of the oxidized second electrode material, at most 50%, preferably at most 20%, of said thickness.

The device comprising the oxidizing agent suitable for being moveable between the first electrode and the second electrode typically means that the oxidizing agent is at a location from which it may be moved between the first and second electrode. In embodiments, the oxidizing agent is located along the passage between the first and second electrode. In embodiments, the first electrode interface comprises said first electrode material oxidized by the oxidizing agent, and/or the second electrode interface comprises said second electrode material oxidized by the oxidizing agent. This is, however, not required. In embodiments, the threshold switch layer comprises said first electrode material. In particular directly after fabrication, the oxidizing agent may be substantially completely contained in the threshold switch layer. In some embodiments, the oxidizing agent may be an ion of the composition of the material of the threshold switch layer.

In embodiments, when the first electrode interface comprises the first electrode material oxidized by the oxidizing agent, substantially the complete first electrode interface is oxidized by the oxidizing agent. When the complete interface between the threshold switch layer and the first electrode interface is formed of the oxidized first electrode material, the only electric path between the threshold switch layer and the first electrode is through the oxidized first electrode material. As a result, the threshold voltage may effectively be influenced by the presence of the oxidized first electrode material.

In embodiments, when the second electrode interface comprises the second electrode material oxidized by the oxidizing agent, substantially the whole second electrode interface is oxidized by the oxidizing agent. In embodiments, when the complete interface between the threshold switch layer and the second electrode interface is formed of the oxidized second electrode material, the only electric path between the threshold switch layer and the second electrode is through the oxidized second electrode material. As a result, the threshold voltage may effectively be influenced by the presence of the oxidized second electrode material.

The voltage between the first and second electrode is typically the voltage at least across the first electrode interface (including said oxidized interfacial layer comprising the oxidized first electrode material at the first electrode interface, if present), the threshold switch layer and the second electrode interface (including said oxidized interfacial layer comprising the oxidized second electrode material at the second electrode interface, if present). Hence, the magnitude of the threshold voltage for the device is typically dependent on the resistance across the first electrode interface, the resistance across the threshold switch layer and the resistance across the second electrode interface.

The second electrode material is electrically conducting, or exhibits metallic behavior, independent of whether it is oxidized by the oxidizing agent.

However, the electrical conductivity of the first electrode material is strongly dependent on whether it is oxidized by the oxidizing agent. If the first electrode material is not oxidized, it is electrically conducting, or exhibits metallic behavior. If the first electrode material is oxidized, it is electrically insulating.

Thus, if the second electrode interface comprises said second electrode material oxidized by the oxidizing agent, the second electrode interface is still electrically conducting. If, at the same time, the first electrode material at the first electrode interface is substantially not oxidized by the oxidizing agent, it is conducting as well. This may result in a magnitude of the threshold voltage of the device being low, substantially only determined by a threshold voltage inherent to the threshold switch layer itself.

However, if the first electrode interface comprises said first electrode material oxidized by the oxidizing agent, such that at least a continuous (or: closed sub-) layer is formed by the first electrode material oxidized by the oxidizing agent, the first electrode interface is electrically insulating. The electrically insulating interface effectively increases the voltage between the first and second electrode that is required for switching the threshold switch layer, as said voltage must also be sufficient for generating a current through the electrically insulating interface. Therefore, this may result in a magnitude of the threshold voltage being high.

In embodiments, the first electrode interface comprises said first electrode material oxidized by the oxidizing agent, and the second electrode interface substantially does not contain said second electrode material oxidized by the oxidizing agent. In embodiments, the second electrode interface comprises said second electrode material oxidized by the oxidizing agent, and the first electrode interface substantially does not contain said first electrode material oxidized by the oxidizing agent. In embodiments, both the first electrode interface comprises said first electrode material oxidized by the oxidizing agent, and the second electrode interface comprises said second electrode material oxidized by the oxidizing agent. However, the magnitude of the threshold voltage may mainly or substantially exclusively depend on the amount of oxidizing agent at the first electrode interface. As the oxidizing agent is moveable between the first and second electrode, and may thus be moved from the first electrode interface to the second electrode interface, and/or from the second electrode interface to the first electrode interface, the threshold voltage may be tuned. This capability allows for on-line (e.g., in-situ, or in-use, or in-operation) tuning of the threshold voltage by simply adapting the polarity of the applied voltage for moving the oxidizing agent between the electrodes. Such a feature is beneficial not only for memory storage purposes - in which the tunable voltage may be representative of data stored in the device - but also for other applications that require dynamic adjustment of the threshold voltage without physical alterations to the device structure.

In embodiments, the threshold switch layer is an ovonic threshold switch layer, wherein the ovonic threshold switch layer is switchable from the electrically resistive state to the electrically conductive state when the applied voltage crosses, e.g., rises above, the threshold voltage, and switchable from the electrically conductive state to the electrically resistive state when the applied voltage crosses, e.g., drops below, a certain hold voltage. (See also FIG. 9.) The threshold voltage is typically different from the hold voltage - in particular, a magnitude of the threshold voltage is typically higher than a magnitude of the hold voltage - due to the ovonic threshold switch exhibiting a negative differential resistance resulting in a hysteresis effect for the conductivity of the ovonic threshold switch. Thus, the threshold switch layer may be, at an applied voltage that is intermediate between the threshold voltage and the hold voltage, either in the conductive state if the intermediate applied voltage was reached by the applied voltage crossing, e.g., dropping below, the threshold voltage, or in the insulating state if the intermediate applied voltage was reached by the applied voltage crossing, e.g., rising above, the hold voltage. Ovonic threshold switches may facilitate robustly accessing individual memory elements of a memory array.

In embodiments, the switchable material comprised in the threshold switch layer is a chalcogenide. In embodiments, the ovonic threshold switch layer may be a chalcogenide layer. The chalcogenide layer may comprise, or consist of, a chalcogenide that is typically in amorphous or in a glass state. It is an advantage of these embodiments that chalcogenides may be good ovonic threshold switches. Examples of chalcogenides exhibiting ovonic threshold switching are germanium sulfide, germanium selenide, germanium telluride, silicon telluride, arsenic telluride, antimony selenide, antimony telluride, indium selenide, indium telluride, and tin selenide. In addition to these binary compounds, ovonic threshold switching can also occur in more complex chalcogenide alloys, where layers often contain three, four, or even more elements. Further examples of chalcogenides exhibiting ovonic threshold switching include alloys such as Si-Ge-S, Si-Ge-As-Te, Si-Ge-As-Se, and Si-Ge-As-Se-Te, among many other possible combinations. The chalcogenide of embodiments of the present invention may comprise or consist of any of these materials, or may be formed of still other chalcogenides exhibiting ovonic threshold switching.

Unlike phase-change materials, which may switch between amorphous and crystalline states during operation, the ovonic threshold switch layer comprising the chalcogenide material typically remains in the amorphous state after the switching event or electrical stimulus is removed. Although the mechanism behind this reversible switching is still under debate, an explanation may be found in the metastable formation of newly introduced metavalent bonds under the application of the applied voltage above the threshold voltage, and the termination of these newly introduced metavalent bonds when the applied voltage is below the holding voltage (see, e.g., Noé et al., Toward ultimate nonvolatile resistive memories: The mechanism behind ovonic threshold switching revealed, Science Advances 6 (2020) eaay2830).

So, when the threshold voltage of the chalcogenide is crossed, the chalcogenide transitions from the electrically insulating state to the electrically conducting state. The state transition involves breaking and rearranging bonds between atoms, which requires energy that may be provided by applying said voltage. As a result, this change in state is typically associated with heating of the chalcogenide.

The heat thus generated may induce release of the oxidizing agent from the interface. Therefore, the first electrode interface and the second electrode interface are located adjacent to the chalcogenide, and are preferably in direct contact therewith.

An additional advantage of the generated heat is that, at elevated temperatures, the permeability of the chalcogenide towards the oxidizing agent is typically increased. Chalcogenides are typically, however, conducting towards the oxidizing agent in both the electrically conducting and electrically insulating state.

Although the threshold switch layer comprises, or is, preferably a chalcogenide, other threshold switch materials, such as other ovonic threshold switch materials, may be used instead. In embodiments, the threshold switch layer may be provided in, or switchable to, a stage in which the threshold switch layer is permeable to the oxidizing agent for providing said passage, e.g., by heating of the threshold switch layer and/or the threshold switch layer being provided in, or switchable to, a material form in which it is permeable to the oxidizing agent.

In embodiments, the threshold switch layer providing a passage for moving the oxidizing agent between the first electrode and the second electrode means that the device is arranged so that a passage is provided from the first electrode, through the threshold switch layer, to the second electrode, for moving the oxidizing agent between the first electrode and the second electrode. In embodiments, the threshold switch layer providing a passage for moving the oxidizing agent between the first electrode and the second electrode means that, although, in principle, further layers could be present between the first electrode and the threshold switch layer, and/or between the second electrode and the threshold switch layer, such further layers are permeable, or not blocking, towards the oxidizing agent. In embodiments, the threshold switch layer providing a passage for moving the oxidizing agent between the first electrode and the second electrode means that the threshold switch layer may be in a material form in which, or may be heated so that, the threshold switch layer is permeable to the oxidizing agent. Chalcogenides typically allow for movement of the oxidizing agent through the chalcogenides in both the electrically insulating and the electrically conducting state, although the permeability of the chalcogenide is typically strongly enhanced when the layer is heated.

The oxidizing agent being suitable for being moveable between the first electrode and the second electrode typically means that the oxidizing agent is of a type that is moveable between the first and second electrode. Typically, the oxidizing agent is an anion. In embodiments, the oxidizing agent may comprise, or may be selected from a list consisting of, oxide, sulphide, selenide, telluride, or combinations thereof. These ions can form stable oxidized electrode materials. In embodiments, the oxidizing agent may be oxide. Oxide may form stable bonds with the electrode interfaces, providing good memory functionality, while being well moveable through threshold switch layers such as chalcogenides.

In embodiments, the threshold switch layer may comprise a catalyst for facilitating dissociation of the oxidizing agent from the electrode interfaces. The catalyst may reduce the energy barrier for breaking of the bond between the oxidizing agent and the electrode interface. The catalyst is typically moveable through the threshold switch layer, which is typically the case when the threshold switch layer comprises the chalcogenide. Preferably, the threshold switch layer may be permeable to the catalyst, for example, when the threshold switch layer is the chalcogenide, heated by the state transition from the electrically insulating state to the electrically conducting state. In embodiments, the catalyst has a charge of a first sign, opposite to a second sign of a charge of the oxidizing agent. In embodiments, the catalyst is cationic. In these embodiments, the catalyst may flow - under application of an electric field for inducing movement of the oxidizing agent - in an opposite direction with respect to the reducing agent, which is typically an anion. As a result, during programming operations, the catalyst may accumulate at the interface where the thermal decomposition reaction, for releasing the oxidizing agent from the interface oxidized by the oxidizing agent, occurs. These catalysts can alter the local structure and bonding environment, making it energetically favourable for oxidizing agents to move from the interface into the chalcogenide. The catalyst may be a transition metal. In embodiments, the catalyst is selected from a list consisting of: nickel, indium, cobalt, platinum, or combinations thereof. In embodiments, the threshold switch layer, e.g., the chalcogenide, may comprise 5 at-% of the catalyst, as fraction of the total amount of atoms in the threshold switch layer. When the threshold switch layer is heated, e.g., by switching from its electrically insulating to its electrically conducting state, its permeability towards the catalyst may be greatly enhanced.

In embodiments, within the threshold switch layer, a concentration of a chemical element, from group 15 or group 16, and from period 3 or higher, is higher in a first region contacting an electrode interface amongst the first and second electrode interface comprising the oxidizing agent than in a second region separated from said electrode interface comprising the oxidizing agent by said first region. In embodiments, the chemical element, from group 15 or group 16, and from period 3 or higher, may comprise, or consist of, tellurium (Te), sulfur (S), selenium (Se), or combinations thereof. Preferably, the threshold switch layer may be permeable to the chemical element, for example, when the threshold switch layer is the chalcogenide, heated by the state transition from the electrically insulating state to the electrically conducting state.

In embodiments, the first electrode may consist of the first electrode material. In embodiments, the first electrode material may comprise molybdenum, tantalum, titanium or titanium nitride. In embodiments, the first electrode material may be selected from a list consisting of: molybdenum, tantalum, titanium, titanium nitride, or combinations thereof. These materials become - when oxidized by the oxidizing agent -electrically insulating.

In embodiments, the second electrode may consist of the second electrode material. In embodiments, the second electrode material may comprise indium-tin-oxide, ruthenium, or tungsten. In embodiments, the second electrode material may be selected from a list consisting of: indium-tin-oxide, ruthenium, tungsten, or combinations thereof. These materials remain electrically conducting when oxidized by the oxidizing agent; in particular, these materials form electrically conducting oxides or conducting sub-stoichiometric oxides.

Any features of any embodiment of the first aspect may be independently as correspondingly described for any embodiment of any of the other aspects of the present invention.

In a second aspect, the present invention relates to a memory element comprising the device of any embodiments of the first aspect.

In embodiments, the oxidized first electrode material (oxidized by the oxidizing agent) being electrically insulating may mean that the oxidized first electrode material (and optionally the first electrode interface, if comprising the oxidized first electrode material) is an insulator. In embodiments, the oxidized second electrode material (oxidized by the oxidizing agent) being electrically conducting may mean that the oxidized second electrode material (and optionally the second electrode interface, if comprising the oxidized second electrode material), is a conductor. Typically, the first electrode material and the second electrode material (not oxidized by the oxidizing agent) are conductors as well.

In some embodiments, the oxidized first electrode material being electrically insulating and the oxidized second electrode material being electrically conducting may be relative to each other, e.g., the oxidized first electrode material may be "more insulating", or may have a "lower conductivity", than the oxidized second electrode material (e.g., both may be a conductor (or both may be an insulator), but there is a difference in conductivity). In embodiments, an electric conductance (and/or conductivity) of the first electrode interface, if comprising the oxidized first electrode material, (e.g., of the oxidized interfacial layer at the first electrode interface) may be lower than an electrical conductance (and/or conductivity) of the second electrode interface, if comprising the oxidized second electrode material (e.g., of the oxidized interfacial layer at the second electrode interface). This asymmetry or difference in conductance and/or conductivity may be so that the threshold voltage may depend on whether the oxidizing agent is at the first or at the second electrode interface. As such, at least part, or all, of the oxidizing agent may be moved between the first and second electrode interface so as to tune the threshold voltage. The conductivity of the oxidized first electrode material is typically also lower than that of the first electrode material and/or the second electrode material (not oxidized by the oxidizing agent). Typically, the first and second electrode material are different, e.g., have a different chemical composition.

In embodiments, the memory element may be associated with a tuneable threshold voltage representing data stored in the memory element. For example, the threshold voltage, or the magnitude of the threshold voltage, being high may represent binary "0" being stored in the memory element, and the threshold voltage, or the magnitude of the threshold voltage, being low may represent binary "1" being stored in the memory element.

The memory element may be adapted for, when data is programmed into the memory element, moving the oxidizing agent between the bottom electrode and the top electrode for changing an amount of oxidized first material at the first electrode interface, and/or an amount of oxidized second material at the second electrode interface, for tuning said threshold voltage.

Any features of any embodiment of the second aspect may be independently as correspondingly described for any embodiment of any of the other aspects of the present invention.

In a third aspect, the present invention relates to a method for programming data into the memory element of any embodiments of the second aspect, comprising applying a programming voltage to the memory element for inducing a movement of said oxidizing agent between the first electrode and the second electrode so as to change an amount of oxidized first material at the first electrode interface and/or an amount of oxidized second electrode material at the second electrode interface, thereby tuning the threshold voltage.

The programming voltage is typically applied between the first and second electrode. In embodiments, said programming voltage may be applied so as to tune said threshold voltage by at least 0.1 V, preferably by at least 0.3 V, more preferably by at least 0.5 V, even more preferably by at least 1.0 V. When the threshold voltage is tuned by a large voltage, reading from the memory element may be facilitated.

In embodiments, the programming voltage may be applied for setting the threshold switch layer from the electrically insulating state into the electrically conducting state. In particular for chalcogenides, transitioning from the electrically insulating state to the electrically conducting state is associated with heating of the threshold switch layer. The heat may result in a high moveability of the oxidizing agent through the threshold switch layer, and furthermore, may induce release of the oxidizing agent from the interfaces. In embodiments, the programming voltage may be applied so as to heat the threshold switch layer so that the threshold switch layer is permeable towards the oxidizing agent. In embodiments, the programming voltage may be applied so as to heat the threshold switch layer so that the oxidizing agent is released from the first electrode interface and/or the second electrode interface.

Any features of any embodiment of the third aspect may be independently as correspondingly described for any embodiment of any of the other aspects of the present invention.

In a fourth aspect, the present invention relates to a method for reading data from the memory element of any embodiments of the second aspect, comprising applying a read voltage to the memory element for determining a value representative of the threshold voltage.

The read voltage is typically applied between the first and second electrode. The read voltage is typically adapted so that the oxidizing agent at the first or second electrode interface is substantially not released, so that nondestructive reading may be achieved. For example, the read voltage may be applied for a sufficiently short time so that substantially no movement of the oxidizing agent between the electrodes occurs.

In embodiments, said value representative of the threshold voltage may be (or, e.g., based on) a current between the first and second electrode, sensed, e.g., by a controller. The thus sensed current may depend on a position of the read voltage with respect to the threshold voltage. For example, when the read voltage is applied, and the current is above a particular predetermined current, the read voltage may be assumed to be above the (value representative of the) threshold voltage. For example, when the read voltage is applied, and the current is below the particular predetermined current, the read voltage may be assumed to be below the (value representative of the) threshold voltage. In embodiments, said value representative of the threshold voltage may be a binary value that is dependent on the threshold voltage being below or above said read voltage. The binary value is typically a data representation using two discrete states, typically denoted as "0" and "1". This allows simple binary data storage. However, this is not required, and instead, the read voltage may be tuned so as to determine an exact value for the threshold voltage, which may result in a multi-level memory element, providing dense data storage.

Any features of any embodiment of the fourth aspect may be independently as correspondingly described for any embodiment of any of the other aspects of the present invention.

In a fifth aspect, the present invention relates to a memory apparatus comprising:
a. the memory element of any embodiments of the second aspect, and
b. a controller configured for:
   executing - if instructed to program data into the memory element - the method of any embodiments of the third aspect on the memory element, and
   executing - if instructed to read data from the memory element - the method of any embodiments of the fourth aspect on the memory element.

In absence of, or inbetween, operations, such as read or programming operations, a magnitude of the voltage applied to the device by the controller may be below a magnitude of the hold voltage so that the threshold switch is in the electrically insulating state. Hence, when a read or programming operation is executed, this typically implies a shift in voltage applied to the device, shifting from a voltage having a magnitude below the magnitude of the hold voltage, to the read or programming voltage.

The controller may comprise instructions for, when instructed to read data, applying a predetermined, or pre-programmed, read voltage to the memory element, i.e., between the first and second electrode. A magnitude of the predetermined read voltage may be between a magnitude of the threshold voltage in its high state, e.g., representing binary "0" (e.g., when the first electrode interface comprises the first electrode material oxidized by the oxidizing agent), and a magnitude of the threshold voltage in its low state, e.g., representing binary "1" (e.g., when the second electrode interface comprises the second electrode material oxidized by the oxidizing agent, and typically the first electrode interface substantially does not comprise the oxidizing agent). The controller may be adapted for sensing a current through the memory element in response to the applied read voltage. When the sensed current is high, it may be assumed that applying the read voltage resulted in crossing of the threshold voltage so that the threshold switch layer is in the electrically conducting state, and the threshold voltage is low. When the sensed current is low, it may be assumed that applying the read voltage did not result in crossing of the threshold voltage so that the threshold switch layer is still in the electrically insulating state, and the threshold voltage is high.

In embodiments, when instructed to program data into the memory element, the programming voltage is applied by the controller to the memory element, i.e., between the first and second electrode. A magnitude of the programming voltage is typically larger than a magnitude of the threshold voltage so that the threshold switch layer is switched from the electrically insulating state to the electrically conducting state. The magnitude of the programming voltage is preferably larger than the magnitude of the threshold voltage when the threshold voltage is high, e.g., represents binary "0", so that the threshold switch layer may be switched from the electrically insulating state to the electrically conducting state independent of whether the threshold voltage is high or low.

In embodiments, the controller may comprise first programming (e.g., one of set and reset) instructions for - when instructed to program first data (e.g., one of binary "1" and "0") into the memory element - applying said programming voltage for inducing a movement of said oxidizing agent in a direction from the first electrode to the second electrode. In embodiments, the controller may comprise second programming (e.g., another of set and reset) instructions for-when instructed to program second data (e.g., another of binary "0" and "1"), different from the first data, into the memory element - applying said programming voltage for inducing a movement of said oxidizing agent in a direction from the second electrode to the first electrode. Throughout the description, specific examples of setting and resetting the memory element are provided; however, the terms "set" and "reset" may be interchanged, or generalized to said programming of first or second data, which may be binary data but that is not essential. Similarly, "1" and "0" may be interchanged, or generalized to said first or second data, which may be binary data but that is not essential.

In case the memory element is for storing binary data, writing data to, or setting, the memory element may comprise applying the programming voltage, which may in that case be called a set voltage, for inducing a movement of the oxidizing agent from the first electrode to the second electrode. In case the memory element is for storing binary data, erasing data from or resetting the memory element may comprise applying the programming voltage, which may in that case be called a reset voltage, for inducing a movement of the oxidizing agent from the second electrode to the first electrode. The set voltage may have an opposite polarity with respect to the reset voltage.

The programming voltage is typically applied independent of the data that is already stored in the memory element. As such, when the programming voltage is applied to program data into the memory element that is already present in the memory element, the threshold voltage may remain substantially the same, as the oxidizing agent is already located at the electrode interface towards which it would be induced to move by the applied programming voltage. For example, in embodiments in which the memory element is for storing binary data, when the memory element comprises stored data representing binary "1", i.e., is in the low threshold voltage state in which the second electrode interface comprises the second electrode material oxidized by the oxidizing agent, and when the programming voltage is a write or set voltage, the threshold voltage may remain substantially the same, so may remain low. Similarly, when the memory element comprises stored data representing binary "0", i.e., is in the high threshold voltage state in which the first electrode interface comprises the first electrode material oxidized by the oxidizing agent, and when the programming voltage is an erase or reset voltage, the threshold voltage may remain substantially the same, so may remain high.

When, however, the programming voltage is applied to program data into the memory element and the memory element contains other data than the data to be programmed, applying the programming voltage may result in said tuning of the threshold voltage. In that case, the threshold voltage of the memory element may be tuned so as to cross the predetermined read voltage (that is typically not applied while applying the programming voltage, but its value is typically pre-programmed or stored in the controller). For example, if the threshold voltage is - before executing said programming - above the predetermined read voltage, the programming voltage may be applied so that the threshold voltage is tuned to cross the predetermined read voltage so that the threshold voltage is tuned to below the predetermined read voltage, typically by the oxidizing agent moving from the first electrode interface to the second electrode interface where it oxidizes the second electrode material. The programming voltage may, in that case, be a set voltage, so that the memory element may be switched from binary "0" to binary "1". For example, if the threshold voltage is - before executing said programming - below the predetermined read voltage, the programming voltage may be applied so that the threshold voltage is tuned to cross the predetermined read voltage so that the threshold voltage is tuned to above the predetermined read voltage, typically by the oxidizing agent moving from the second electrode interface to the first electrode interface where it oxidizes the first electrode material. The programming voltage may, in that case, be a reset voltage, so that the memory element may in that case be switched from binary "1" to binary "0".

Any features of any embodiment of the fifth aspect may be independently as correspondingly described for any embodiment of any of the other aspects of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A is a vertical cross-section of a first exemplary device according to embodiments of the present invention.
FIG. 1B is a diagram of current as dependent on voltage for the device of FIG.1A according to embodiments of the present invention.
FIG. 2A is a vertical cross-section of the device of FIG. 1A, wherein a set voltage is applied to the device.
FIG. 2B is a diagram of current as dependent on voltage for the device of FIG. 2A according to embodiments of the present invention.
FIG. 3A is a vertical cross-section of the device of FIG. 2, wherein the device has been set, so wherein data has been written to the device.
FIG. 3B is a diagram of current as dependent on voltage for the device of FIG.3A according to embodiments of the present invention.
FIG. 4A is a vertical cross-section of the device of FIG. 3A, wherein a reset voltage is applied to the device.
FIG. 4B is a diagram of current as dependent on voltage for the device of FIG. 4A according to embodiments of the present invention.
FIG.5 is a vertical cross-section of a second exemplary device according to embodiments of the present invention.
FIG.6 is a vertical cross-section of the device of claim 5, wherein a set voltage is applied to the device.
FIG.7 is a vertical cross-section of the device of claim 5, wherein the device has been set, so wherein data has been written to the device.
FIG.8 is a schematic representation of a perspective view of a memory apparatus according to embodiments of the present invention.
FIG.9 is a diagram of current as dependent on voltage for an ovonic threshold switch in accordance with the prior art.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B. The term "comprises" may encompass, however, also, in the limit of "no other elements or steps present", the term "consists of", so that the term "comprises" may be understood to provide basis for replacing the term "comprises" by "consists of" as well.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein, any properties of a material, including electrical and ionic conductances or conductivities, and threshold voltages, may be as determined under standard conditions, e.g., 25 °C and/or 101325 Pa (=1atm). Alternatively, said properties may be as determined under the conditions of the material (e.g., temperature of the material and/or under a pressure of the environment). For example, when said property is associated with a state transition that occurs at elevated temperatures, the properties may be that under said elevated temperatures. For example, during a method, said properties are typically as determined while performing said method. In case the property is directional, these properties may be determined along a relevant direction, e.g., for the conductivities and conductances and threshold voltage, along a direction between the first and the second electrode. The electrical conductivities may be determined by any technique known in the art, such as the Van der Pauw method, or the two-point or four-point probe method.

As used herein, and unless otherwise specified, when a material is said to be "electrically insulating", the material exhibits high electrical resistance. For example, when the threshold switch layer is said to be in an electrically insulating state, the threshold switch layer effectively prevents the flow of electric current under normal operating voltages. In embodiments, a material that is electrically insulating may have an electrical conductivity of at most 1 S/m, preferably at most 10⁻¹ S/m, more preferably at most 10⁻² S/m, even more preferably at most 10⁻³ S/m, yet more preferably at most 10⁻⁴ S/m. Specifically, when a material is said to be "electrically insulating", the electrical conductivity may be at most 1 S/m. In embodiments, the oxidized first electrode material may have an electrical conductivity of at most 1 S/m. In embodiments, the oxidized interfacial layer at the first electrode may have an electrical conductivity of at most 1 S/m. In embodiments, the switchable material of the threshold switch layer in the electrically insulating state may have an electrical conductivity of at most 1 S/m.

As used herein, and unless otherwise specified, when a material is said to be "electrically conducting", the material exhibits low electrical resistance. For example, when the threshold switch layer is said to be in an electrically conducting state, the threshold switch layer effectively allows electric current to flow under an applied voltage. In embodiments, a material that is electrically conducting may have an electrical conductivity of at least 10² S/m, preferably at least 10³ S/m, more preferably at least 10⁴ S/m. Specifically, when a material is said to be "electrically conducting", the electrical conductivity may be at least 10² S/m. In embodiments, the first electrode (when not oxidized) may have an electrical conductivity of at least 10² S/m. In embodiments, the first electrode material (when not oxidized) may have an electrical conductivity of at least 10² S/m. In embodiments, the second electrode (when not oxidized) may have an electrical conductivity of at least 10² S/m. In embodiments, the second electrode material (when not oxidized) may have an electrical conductivity of at least 10² S/m. In embodiments, the oxidized second electrode material may have an electrical conductivity of at least 10² S/m. In embodiments, the oxidized interfacial layer at the second electrode may have an electrical conductivity of at least 10² S/m. In embodiments, the switchable material of the threshold switch layer when in the electrically conducting state may have an electrical conductivity of at least 10² S/m, which may be measured under the conditions where the material is in its conducting state, i.e., at the elevated local temperature achieved during switching operation. Generally, however, as the skilled person knows, threshold switches, in particular ovonic threshold switches, may rather be associated with a strong shift, or change, in conductivity when crossing the threshold voltage, rather than with particular conductivities.

As used herein, and unless otherwise specified, when a material is said to be permeable to an ion, e.g., catalyst or oxidizing agent, the material may conduct the ion efficiently. In embodiments, a material is deemed permeable to the ion when it exhibits a conductivity towards the ion of at least 10⁻⁵ S/m, preferably at least 10⁻³ S/m, more preferably at least 10⁻¹ S/m, even more preferably at least 1 S/m. Specifically, when a material is said to be permeable to the ion, the electrical conductivity may be at least 10⁻⁵ S/m.

As used herein, and unless otherwise specified, when a material is said to be blocking to the ion, the material may substantially not conduct the ion. In embodiments, a material is deemed blocking to the ion when it exhibits a conductivity towards the ion of at most 10⁻⁶ S/m, preferably at most 10⁻⁸ S/m, more preferably at most 10⁻¹⁰ S/m. Specifically, when a material is said to be blocking to the ion, the electrical conductivity may be at most 10⁻⁶ S/m.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a device comprising:
a. a first electrode comprising a first electrode material of a type that, if oxidized by an oxidizing agent, is electrically insulating,
b. a second electrode comprising a second electrode material of a type that, if oxidized by said oxidizing agent, is electrically conducting, and
c. a threshold switch layer between the first electrode and the second electrode, the threshold switch layer comprising a material being switchable from an electrically insulating state to an electrically conducting state by a voltage between the first and second electrode crossing a threshold voltage, and
d. a first electrode interface between the threshold switch layer and the first electrode, and a second electrode interface between the threshold switch layer and the second electrode,
wherein the device comprises the oxidizing agent suitable for being moveable between the first electrode and the second electrode, the threshold switch layer providing a passage for moving the oxidizing agent between the first electrode and the second electrode.

In a second aspect, the present invention relates to a memory element comprising the device of any embodiments of the first aspect. In embodiments, the memory element may be associated with a tuneable threshold voltage representing data stored in the memory element. The memory element may be adapted for, when programming data into the memory element, moving the oxidizing agent between the bottom electrode and the top electrode for changing an amount of oxidized first material at the first electrode interface, and/or an amount of oxidized second material at the second electrode interface, for tuning said threshold voltage.

In a third aspect, the present invention relates to a method for programming data into the memory element of any embodiments of the second aspect, comprising applying a programming voltage to the memory element for inducing a movement of said oxidizing agent between the first electrode and the second electrode so as to change an amount of oxidized first material at the first electrode interface and/or an amount of oxidized second electrode material at the second electrode interface, thereby tuning the threshold voltage.

In a fourth aspect, the present invention relates to a method for reading data from the memory element of any embodiments of the second aspect, comprising applying a read voltage to the memory element for determining a value representative of the threshold voltage.

The present invention provides a memory and operation method that relies on reversible oxidation of asymmetric electrode interfaces (resulting from the use of an asymmetric stack) to achieve binary or multilevel data storage capability. The simple device structure may enable low-cost, high-density memory suitable for storage-class memory applications.

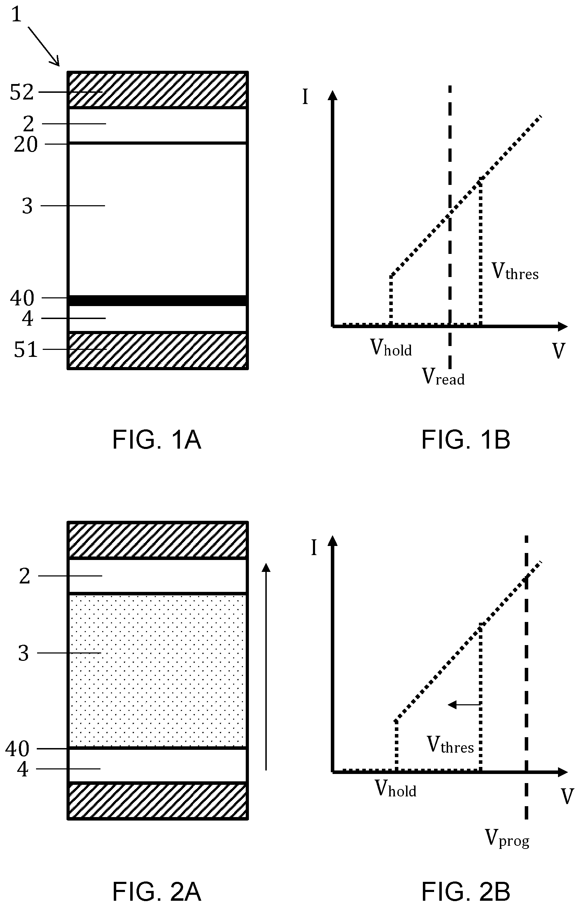

As illustrated in FIG. 1A, a vertical cross-section of a first exemplary device (1) of the present invention is shown. The device (1) comprises a stack of layers. The stack of layers comprises a bottom diffusion barrier (51), and a first electrode (4) over or on the bottom diffusion barrier (51). The first electrode (4) comprises a first electrode interface (40) between the first electrode (4) and the threshold switch layer (3). The first electrode interface (40) adjacent to, e.g., contacting, the threshold switch layer (3) comprises the first electrode material oxidized by the oxidizing agent, making it electrically insulating. In other words, the device (1) may comprise an electrically insulating oxidized interfacial layer (40), comprising the first electrode material oxidized by the oxidizing agent, at the first electrode interface (40). Preferably, substantially the complete interface (40) is oxidized, i.e., comprises the first electrode material oxidized by the oxidizing agent. Preferably, the oxidized first electrode material at the first electrode interface (40) separates the rest (e.g., the electrically conducting or non-oxidized part) of the first electrode (4) from the threshold switch layer (3).

The stack of layers further comprises a threshold switch layer (3) over or on the first electrode (4), and a second electrode (2) over or on the threshold switch layer (3). The first electrode (4) and the second electrode (2) are thus separated from each other by the threshold switch layer (3). The second electrode (2) comprises a second electrode interface (20) between the second electrode (2) and the threshold switch layer (3). The second electrode interface (20) does not comprise the oxidizing agent. This is not strictly required, however, and the second electrode interface (20) may instead be oxidized with the oxidizing agent as well, as the second electrode interface (20) is electrically conducting independent of whether it is oxidized or not.

The stack further comprises a top diffusion barrier (52) over or on the second electrode (2). The bottom diffusion barrier (51) and the top diffusion barrier (52) are substantially blocking or impermeable towards the oxidizing agent. Read and program voltages may be applied to the first (4) and second electrode (2) via the bottom (51) and top diffusion barrier (52), respectively, thereby preventing diffusion of the oxidizing agent out of the device (1). The bottom diffusion barrier (51) and the top diffusion barrier (52) are typically formed of an electrically conducting material. The bottom diffusion barrier (51) and the top diffusion barrier (52) may, for example, be formed of amorphous carbon.

Preferably, the first electrode interface (40) is an interface between the first electrode (4) and the threshold switch layer (3). Similarly, the second electrode interface (20) is preferably an interface between the second electrode (2) and the threshold switch layer (3). In other words, preferably, the threshold switch layer (3) directly contacts the first electrode interface (40) and the second electrode interface (20). This direct contact may provide good thermal coupling between the threshold switch layer (3) and the electrode interfaces (20, 40). The good thermal coupling may be advantageous for releasing the oxidizing agent from the electrode interface (20, 40) when the threshold switch layer (3) is heated. Furthermore, such direct contact may enable direct movement of the oxidizing agent between the electrode interfaces (20, 40) into the threshold switch layer (3) on their release, which may be advantageous for providing good movability of the oxidizing agent between the first electrode (4) and the second electrode (2).

In the present example, the threshold switch layer (3) comprises a catalyst for facilitating dissociation of the oxidizing agent from the electrode interfaces (20, 40). Direct contact between the threshold switch layer (3) and the interfaces (20, 40) allows the catalyst in the threshold switch layer (3) to reach the electrode interfaces (20, 40), where the catalyst may lower the energy barrier for breaking of the bond between the oxidizing agent and the electrode interface (20, 40).

The threshold switch layer (3) is, in the present example, a chalcogenide. In embodiments, the catalyst has a charge of a first sign, opposite to a second sign of a charge of the oxidizing agent. The oxidizing agent is typically negatively charged, so that the catalyst is preferably positively charged.

Referring to FIG. 1B, the current-voltage characteristics of the device (1) in FIG. 1A are depicted. The threshold voltage (Vₜₕᵣₑₛ) is high because the insulating layer at the first electrode interface (40) limits current injection. The threshold voltage (Vₜₕᵣₑₛ) is, therefore, higher than a predetermined read voltage (V_{read}), so that when the read voltage (V_{read}) is applied, the threshold voltage (Vₜₕᵣₑₛ) is not crossed and the threshold switch layer (3) remains electrically insulating and is thus in a resistive state. A current sensed in response to the applied read voltage (V_{read}) would thus be low. This state of the device may, for example, correspond to binary "0".

In absence of, or inbetween, operations, such as a read or programming operation, performed on the device (1), a magnitude of the voltage applied to the device (1) may be typically below a magnitude of a hold voltage (V_{hold}), and the threshold switch is in the electrically insulating state. When no read, reset or set voltage is applied, a magnitude of the voltage applied to the device (1) may be 0, or such so that no electrical field is applied across the device (1) so that no movement of the oxidizing agent may be induced.

Simultaneous reference is made to FIG. 2A and FIG. 2B. A write or set operation (V_{prog}) is performed on the device (1). A programming voltage (V_{prog}) is applied between the first electrode (4) and the second electrode (2).

The applied programming voltage (V_{prog}) is larger than the threshold voltage (Vₜₕᵣₑₛ) so that the threshold switch layer (3) is switched from the electrically insulating state into its electrically conducting state.

This change in state is associated with heating of the chalcogenide. In particular, the state transition involves breaking and rearranging bonds between atoms. This bond rearrangement requires energy, which originates from the applied voltage. Consequently, the chalcogenide heats up during the state change.

Said heat may facilitate release of the oxidizing agent from the first electrode interface (40), as the heat may break bonds between the oxidizing agent and the first electrode material of the first electrode (4).

Furthermore, the heated threshold switch layer (3) may have a good permeability towards the oxidizing agent. In addition to this, due to the large amount of free charge carriers (electrons/holes) in the electrically conductive state, the chalcogenide typically has a higher permeability towards the oxidizing agent in particular in the electrically conductive state.

The programming voltage (V_{prog}), furthermore, is applied such that an electric field across the threshold switch layer (3) induces movement (e.g., due to electrophoresis) of the oxidizing agent from the first electrode (4) to the second electrode (2).

As such, the applied field results in efficient release and movement of the oxidizing agent from the first electrode interface (40) to the second electrode interface (20). The movement of the negatively charged oxidizing agent is indicated by the arrow. At the same time, the catalyst moves in the opposite direction as the arrow, towards the first electrode interface (40), where it catalyzes the release of the oxidizing agent from the first electrode interface (40).

As a result of the movement of the oxidizing agent, wherein the oxidizing agent is removed from the first electrode interface (40) and moved to the second electrode interface (20) where it now oxidizes the second electrode material, the threshold voltage decreases, as indicated by the arrow in FIG. 2B.

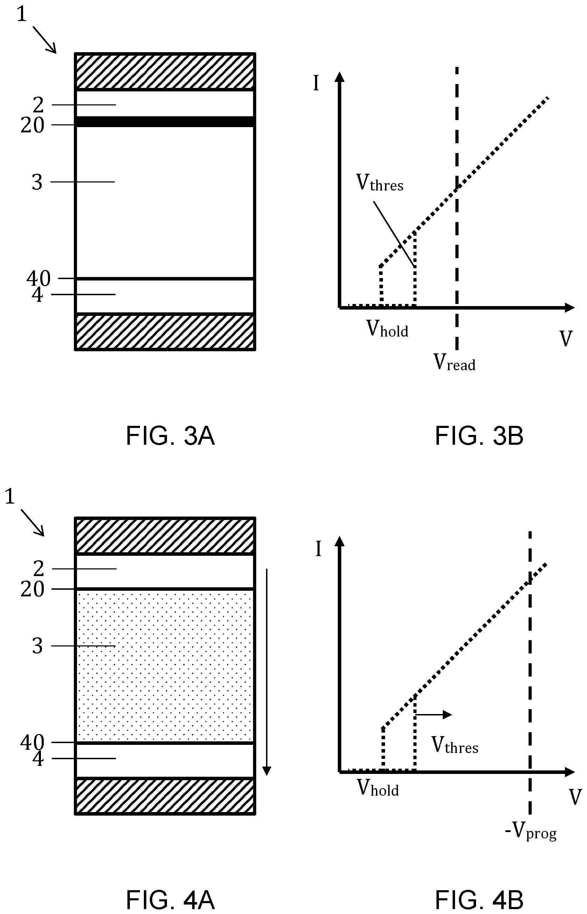

After the set operation, as shown in FIG. 3A, the device (1) has the oxidizing agent located at the second electrode interface (20). In other words, the device (1) may comprise an electrically conducting oxidized interfacial layer (20), comprising the second electrode material oxidized by the oxidizing agent, at the second electrode interface (20). Preferably, the oxidized second electrode material at the second electrode interface (20) separates the rest (i.e., the non-oxidized part) of the second electrode (2) from the threshold switch layer (3). The programming voltage may be ceased and a voltage below a hold voltage (V_{hold}) may be applied so that the threshold switch layer (3) transitions back into the electrically insulating state. The first electrode interface (40) may now be substantially free of the oxidizing agent and may, thus, be electrically conducting. Correspondingly, FIG. 3B presents the current-voltage characteristics of the device (1) in FIG. 3A. The threshold voltage (Vₜₕᵣₑₛ) is now low because of efficient current injection from the oxidizing agent-free first electrode interface (40), while the second electrode interface (20) remains electrically conductive. The threshold voltage (Vₜₕᵣₑₛ) is now below said predetermined read voltage (V_{read}), so that it may be determined that the device (1) is in the low-resistance state. This state of the device may, for example, correspond to binary "1".

An erase or reset operation is depicted in FIG. 4A, with simultaneous reference to FIG. 4B, comprising applying a programming voltage that is a reset voltage (-V_{prog}; of which the absolute value is shown, but having a negative sign to indicate the opposite polarity with respect to the programming voltage V_{prog} applied in FIG. 2A and 2B) across the device (1). The reset voltage (-V_{prog}) has an opposite sign or polarity than the set voltage (V_{prog}), in the sense that it generates an electric field in the opposite direction (with respect to FIG. 2A and 2B) between the first electrode (4) and the second electrode (2). The magnitude of the reset voltage (-V_{prog}) is, again, larger than the magnitude of the threshold voltage (Vₜₕᵣₑₛ) so that the threshold switch layer (3) transitions again to the electrically conducting state. Typically, the magnitude of the programming voltage (V_{prog}), that is, each of the magnitude of the set voltage (V_{prog}) and the magnitude of the reset voltage (-V_{prog}), is larger than the magnitude of the high threshold voltage, i.e., of the threshold voltage in the state in which it is high (so when the first interface comprises the first electrode material oxidized by the oxidizing agent). In that case, the threshold switch layer is switched from the electrically insulating state to the electrically conducting state. In the present example, the reset voltage (-V_{prog}) and the set voltage (V_{prog}) have a same magnitude; however, this is not required and instead, different magnitudes could be used. As the applied field is now generated in an opposite direction, the oxidizing agent, released from the second electrode material at the second electrode interface (20), is moved back (for which the direction is indicated by the arrow in FIG. 4A) from the second electrode interface (2) to the first electrode interface (4). This resets the device (1) to the state shown in FIG. 1A, restoring the high threshold voltage (Vₜₕᵣₑₛ) due to the insulating oxidized layer at the first electrode interface (40).

Although the present example uses the device (1) for storing binary data, the invention is not required thereto. Instead, in embodiments of the present invention, the programming voltage may be applied for a particular time so as to achieve a particular threshold voltage. The read voltage may be tuned so as to determine the value representative of the particular threshold voltage.

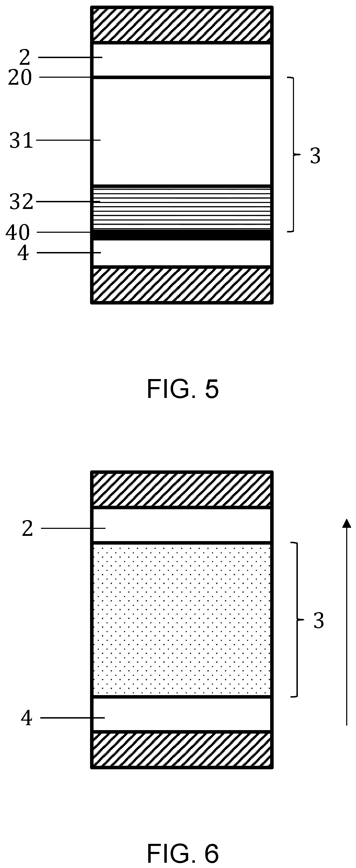

FIG. 5 illustrates a second exemplary device (1), having a concentration gradient of an element from group 15 or 16, and from period 3 or higher, within the threshold switch layer (3). For example, the element may be tellurium (Te), sulfur (S), or selenium (Se). The concentration of this element is higher in a first region (32) near the electrode interface comprising the oxidizing agent - which is, in FIG. 5, the first electrode interface (40) - compared to a second region (31) farther away. Said element may facilitate the release of the oxidizing agent from the interface (20, 40), by facilitating breaking bonds between the oxidizing agent and the interface (20, 40). Indeed, elements from group 15 or 16 have a high electronegativity, and as the element is, furthermore, from period 3 or higher, it is typically reactive towards the oxidizing agent, in particular when the oxidizing agent is oxygen.

As shown in FIG. 6, during a programming operation, e.g., a write or set operation, similar to that in FIG. 2, the programming voltage moves the oxidizing agent to the opposite electrode interface (20). The arrow indicates the movement direction of the oxidizing agent, which is from the first electrode (4) to the second electrode (2). In contrast to the catalyst of the first exemplary embodiment above, said element has a charge having a same sign as the oxidizing agent (e.g., both the oxidizing agent and the element may be anions) and thus moves in the same direction as the oxidizing agent on application of a field through the threshold switch layer (3). Hence, also said element moves in the direction of the arrow.

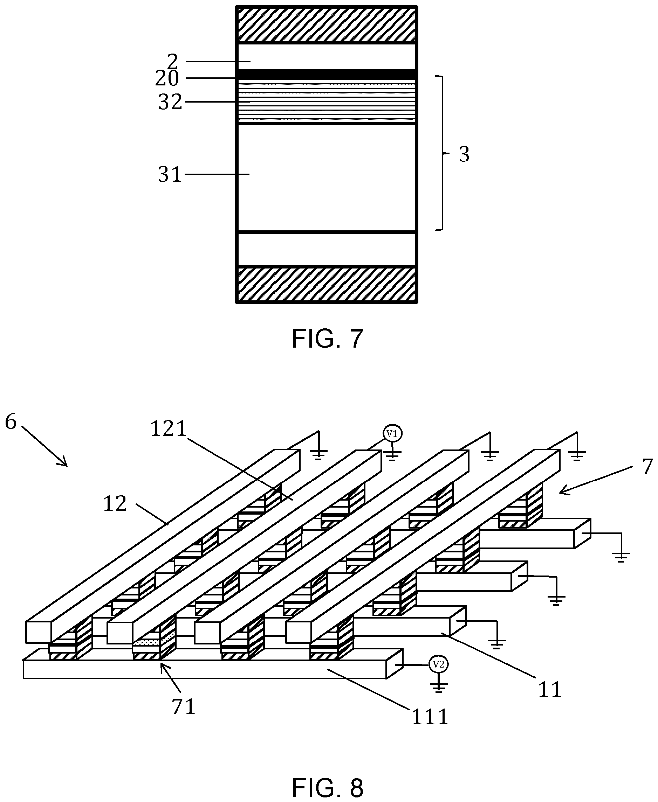

After the set operation, as shown in FIG. 7, the first region (32) with the higher concentration of the group 15 or 16 element has also moved along with the oxidizing agent to the second electrode interface (20). As a result, the first region (32) shifts its position within the threshold switch layer (3) and is now located at the side of the threshold switch layer (3) in contact with the second electrode interface (20), enhancing the device's (1) performance by aiding efficient oxidizing agent release and, hence, migration, in a reset operation that may follow.

In a fifth aspect, the present invention relates to a memory apparatus comprising:
a. the memory element of any embodiments of the second aspect, and
b. a controller configured for:
   executing - if instructed to program data into the memory element - the method of any embodiments of the third aspect on the memory element, and
   executing - if instructed to read data from the memory element - the method of any embodiments of the fourth aspect on the memory element.

FIG. 8 presents a schematic representation of a memory apparatus (6) incorporating the disclosed memory elements (7). The apparatus comprises four parallel column lines (12), forming the bitlines, and four parallel row lines (11), forming the wordlines. The column lines (12) and row lines (11) are conductive, and connected to a controller (not shown) for selectively and independently applying voltages.

Each intersection of a column line (12) and a row line (11) is electrically coupled by a memory element (7) as per the present invention, thereby forming an array of memory elements (7). In the present example, for each memory element (7), the lower electrode interface is oxidized by the oxidizing agent. By applying appropriate voltages V1 and V2 to a specific column line (121) and a specific row line (111), respectively, a programming voltage is applied to a particular memory element (71) at their intersection, allowing for selective programming or reading of the individual memory element (71) in the array of memory elements (7). Indeed, as threshold switch layers are used, that are, in the present example are ovonic threshold switches, in particular, chalcogenides, that may be used as selectors, selective programming and reading of individual memory elements (7) is facilitated. The voltage V1 and V2 are selected such that only the threshold voltage for the particular memory element (71) is crossed, so that only the particular memory element (71) is effectively addressed. For example, V1 and V2 may have an opposite sign.

In FIG. 8, a programming voltage is applied to the particular memory element (71), so that the oxidizing agent is moved between the bottom and top electrode of the memory element (71) (similar as described above for the first and second exemplary device).

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A device (1) comprising:
a first electrode (4) comprising a first electrode material of a type that, if oxidized by an oxidizing agent, is electrically insulating,
a second electrode (2) comprising a second electrode material of a type that, if oxidized by said oxidizing agent, is electrically conducting, and
a threshold switch layer (3) between the first electrode (4) and the second electrode (2), the threshold switch layer (3) comprising a material being switchable from an electrically insulating state to an electrically conducting state by a voltage between the first (4) and second electrode (2) crossing a threshold voltage (Vₜₕᵣₑₛ), and
a first electrode interface (40) between the threshold switch layer (3) and the first electrode (4), and a second electrode interface (20) between the threshold switch layer (3) and the second electrode (2),
wherein the device (1) comprises the oxidizing agent suitable for being moveable between the first electrode (4) and the second electrode (2), the threshold switch layer (3) providing a passage for moving the oxidizing agent between the first electrode (4) and the second electrode (2).

2. The device (1) of claim 1, wherein the threshold switch layer (3) is a chalcogenide layer.

3. The device (1) of claim 1 or 2, wherein, within the threshold switch layer (3), a concentration of a chemical element, from group 15 or group 16, and from period 3 or higher, is higher in a first region (32) contacting an electrode interface (20, 40) amongst the first and second electrode interface comprising the oxidizing agent than in a second region (31) separated from said electrode interface (20, 40) comprising the oxidizing agent by said first region (32).

4. The device (1) of any of the previous claims, wherein the oxidizing agent comprises oxygen, sulphur, selenium or tellurium, preferably oxygen.

5. The device (1) of any of the previous claims, wherein the threshold switch layer (3) comprises a catalyst for facilitating dissociation of the oxidizing agent from the electrode interfaces, said catalyst having a charge of a first sign, opposite to a second sign of a charge of the oxidizing agent.

6. The device (1) of any of the previous claims, wherein the first electrode interface (40) comprises said first electrode material oxidized by the oxidizing agent, and/or
the second electrode interface (20) comprises said second electrode material oxidized by the oxidizing agent.

7. The device (1) of any of the previous claims, wherein the first electrode material comprises molybdenum, tantalum, titanium or titanium nitride.

8. The device (1) of any of the previous claims, wherein the second electrode material comprises indium-tin-oxide, ruthenium, or tungsten.

9. A memory element (7) comprising the device (1) of any of the previous claims.

10. A method for programming data into the memory element (7) of claim 9, comprising applying a programming voltage to the memory element (7) for:
inducing a movement of said oxidizing agent between the first electrode (4) and the second electrode (2) so as to change an amount of oxidized first material at the first electrode interface (40) and/or an amount of oxidized second electrode material at the second electrode interface (20), thereby tuning the threshold voltage (Vₜₕᵣₑₛ).

11. The method of claim 10, wherein said programming voltage is applied so as to tune said threshold voltage by at least 0.1 V, preferably by at least 0.3 V, more preferably by at least 0.5 V, even more preferably by at least 1.0 V.

12. The method of claim 10 or 11, wherein the programming voltage is applied for setting the threshold switch layer (3) from the electrically insulating state into the electrically conducting state.

13. A method for reading data from the memory element (7) of claim 9, comprising applying a read voltage to the memory element (7) for determining a value representative of the threshold voltage (Vₜₕᵣₑₛ).

14. The method of claim 13, wherein said value representative of the threshold voltage (Vₜₕᵣₑₛ) is a binary value that is dependent on the threshold voltage (Vₜₕᵣₑₛ) being below or above said read voltage.

15. A memory apparatus (6) comprising:
the memory element (7) of claim 9, and
a controller configured for:
executing - if instructed to program data into the memory element (7) - the method of any of claims 10 to 12 on the memory element (7), and
executing - if instructed to read data from the memory element (7) - the method of claim 13 or 14 on the memory element (7).
